# EUROPEAN PATENT APPLICATION

(11) **EP 4 016 626 A1**
(43) Date of publication of application: **22.06.2022**
(21) Application number: 21196768.2
(22) Date of filing: 15.09.2021
(51) Int. Cl.: H01L 27/11556, H01L 27/11582

(54) **VERTICAL CHANNEL WITH CONDUCTIVE STRUCTURES TO IMPROVE STRING CURRENT**

(30) Priority: 16.12.2020 US 202017123451
(71) Applicant: Intel Corporation, Santa Clara, CA 95054 (US)
(72) Inventor: Mebrahtu, Henok T., Meridian, 83642 (US); Agarwal, Rahul, Rio Rancho, 87124 (US); Koval, Rand J., Boise, 83716 (US); Huang, Guangyu, El Dorado Hills, 95762 (US)
(74) Representative: Goddar, Heinz J.

(57) **Abstract**

A vertical channel of a three-dimensional (3D) NAND has a recessed and filled drain/source pocket region for each memory cell to reduce resistance in a region that traditionally has high resistance. The vertical channel conducts current whose resistivity is controlled through a series of memory cells. The vertical channel can have a polysilicon material to conduct current past the memory cell gates and drain/sources region between the memory elements. The recess can extend the polysilicon away from a center of the vertical channel and closer to the control gates. The recess includes a structure to reduce resistance in the drain/source region along the vertical channel between memory cell gates.

## Description

### FIELD

Descriptions are generally related to three-dimensional (3D) memory devices, and more particular descriptions are related to vertical channel string current of 3D memory devices.

### BACKGROUND

Semiconductor-based nonvolatile storage devices are used in persistent storage devices, such as disk drives, implemented as solid-state drives (SSDs). Recent improvements in SSD technologies include three-dimensional (3D) storage arrays, which increase the density of cells in the storage device. 3D NAND (not AND, or storage cells based on inverted AND gate logic, commonly referred to as flash storage) is a common technology used in SSDs. 3D NAND arrays have vertical channels, and access the cells based on strings of cells connected via the vertical channels. The ability to access the cells depends on the string current used to charge the vertical channel. Increasing the number of stacks in the 3D array tends to increase the resistance of the vertical channel. String current capability is a limiting factor when trying to scale the 3D NAND devices to increased stack height.

### BRIEF DESCRIPTION OF THE DRAWINGS

The following description includes discussion of figures having illustrations given by way of example of an implementation. The drawings should be understood by way of example, and not by way of limitation. As used herein, references to one or more examples are to be understood as describing a particular feature, structure, or characteristic included in at least one implementation of the invention. Phrases such as "in one example" or "in an alternative example" appearing herein provide examples of implementations of the invention, and do not necessarily all refer to the same implementation. However, they are also not necessarily mutually exclusive.
**Figure 1** is a representation of an example of a vertical channel with conductive structures.
**Figures 2A-2H** are diagrammatic representations of a cross-section of stages of processing of a vertical channel with conductive structures.
**Figures 3A-3H** are diagrammatic representations of a cross-section of stages of processing of a vertical channel with conductive structures.
**Figure** 4 is a flow diagram of an example of a process for creating a 3D memory vertical channel with conductive structures.
**Figure 5A** is a block diagram of an example of a system with a hardware view of a solid state drive (SSD) with a nonvolatile array having a vertical channel with conductive structures.
**Figure 5B** is a block diagram of an example of a logical view of system with a solid state drive (SSD) with a nonvolatile array having a vertical channel with conductive structures.
**Figure** 6 is a block diagram of an example of a computing system in which a 3D memory with a vertical channel with conductive structures can be implemented.
**Figure** 7 is a block diagram of an example of a mobile device in which a 3D memory with a vertical channel with conductive structures can be implemented.

Descriptions of certain details and implementations follow, including non-limiting descriptions of the figures, which may depict some or all examples, and well as other potential implementations.

### DETAILED DESCRIPTION

As described herein, a vertical channel of a three-dimensional (3D) NAND has a recessed in a drain/source region to reduce resistance in a region that traditionally has high resistance. The drain/source region refers to a region between storage cells. The region can be thought of as a source region when it is the source of current carriers for the vertical channel. The region can be thought of as a drain region when it is the region into which the current carriers flow from the source. The vertical channel conducts current past a first storage node of a first memory cell controlled by the vertical channel and past a second storage node of a second memory cell controlled by the vertical channel. The vertical channel can have a polysilicon material to conduct current past the memory cell control gates, and the drain/source region is between vertically adjacent memory cells along the vertical channel. The recess can extend the channel material away from a center of the vertical channel and toward the control gates of the memory cells. The recess includes a structure to reduce resistance in the drain/source region along the vertical channel between memory cell gates. For simplicity in description below, the region of resistance reduction will be referred to as the drain region, which can be understood as applying to a drain region or source region.

The structure to reduce the resistance of the channel has a lower resistivity as compared to the material of the vertical channel. For example, the structure can be a crystalline polysilicon structure, a highly doped polysilicon structure, or a metallic structure. The structure can be identified as a pocket or region of lower resistance material physically adjacent to and electrically connected to the vertical channel material. The inclusion of the structure reduces the resistivity of the area between gates, and lowers the resistance of the overall vertical channel. Lowering the resistance of the vertical channel can improve string current capability, even as the number of layers or stack height increases. Simulations of 3D arrays including the structures show significant improvements in string current. The Increases in the string current can significantly reduce interference (e.g., floating gate to floating gate interference (FG-FG interference), or gate to gate interference).

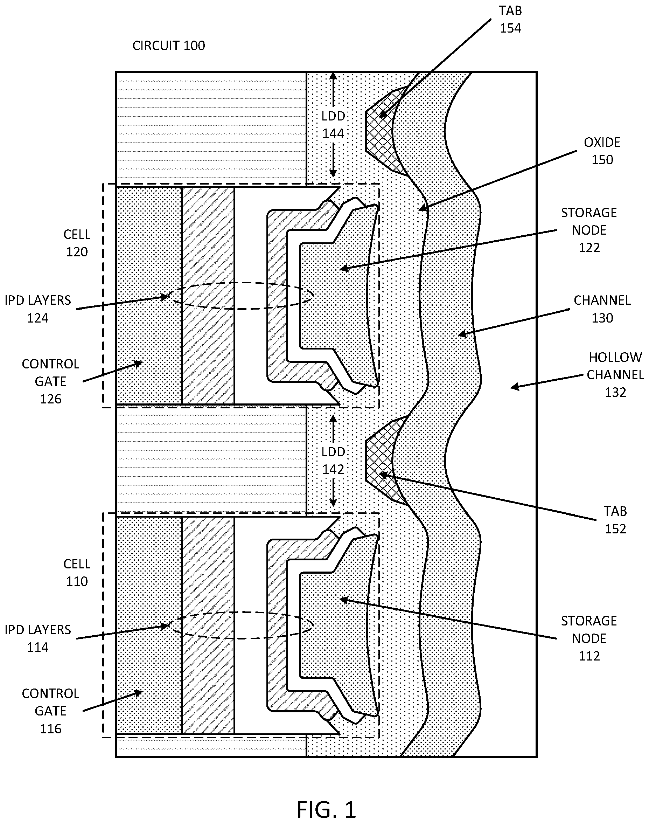

**Figure 1** is a representation of an example of a vertical channel with conductive structures. Circuit 100 represents a portion of a vertical channel in a 3D memory structure, such as a 3D NAND array. Circuit 100 is not necessarily to scale, and illustrates non-limiting example of features rather than providing an exact representation of features.

Circuit 100 represents two memory cells, cell 110 and cell 120. The cells illustrate one example of a memory cell structure, with conductors indicated as storage node 112 and storage node 122, respectively. Storage node 112 is separated from conductor layer poly by one or more IPD layers 114. The conductor layer poly is a layer of conductor to control access to the storage node. The conductor layer poly for storage node 112 is represented as control gate 116. Likewise, storage node 122 is separated from conductor layer poly by one or more IPD layers 124, represented as control gate 126. The number of IPD layer and the structure of those layers is not important for circuit 100, as long as the storage node is electrically isolated from the conductor layer.

In one example, circuit 100 includes channel conductor 130, where the channel conductor forms hollow channel 132. 3D NAND typically uses polycrystalline material for channel 130. Polycrystalline is not fully crystalline, which increases resistance. Fully crystalline material causes very little scattering of the charge carriers, which results in very low resistance. However, the grains in the polycrystalline (poly) material limit the mobility of the carriers. The charge carriers are typically electrons, where conductor 130 is n-doped poly. In one example, conductor 130 is p-doped poly with holes as the charge carriers. In either case, the grains result in increased resistance.

The regions of channel 130 in front of storage node 112 and storage node 122 have lower resistance than the regions of channel 130 that are in front of the tier isolation layers. The regions of higher resistance are indicated as LDD 142 between cell 110 and cell 120 and LDD 144 above cell 120. LDD can refer to a drain or source region induced by current through the channel conductor. The LDD regions refer to the regions of the channel just outside the areas controlled by the control gates, and tend to have higher resistance than the portions of channel 130 in the areas controlled by the gates.

Although circuit 100 is not necessarily to scale, the separation layers between the cells is generally thinner than the cells themselves. The LDD regions are thus shorter in length than the regions in front of the storage nodes. Despite the shorter lengths, LDD resistance in certain 3D NAND devices can account for up to approximately two-thirds of the string resistance for the vertical channel.

In one example, circuit 100 includes tab 152 between cell 110 and cell 120 in the area of LDD 142. In one example, circuit 100 includes tab 154 above cell 120 in the area of LDD 144. Tab 152 and tab 154 are structures built into recesses in the areas that traditionally have high resistance, which can fill the recesses. In one example, tab 152 and tab 154 are highly doped polysilicon to reduce the resistance of channel 130 in the LDD regions. In one example, tab 152 and tab 154 are metal or metallic material that can have a similar effect as highly doped poly to reduce the resistance of channel 130 in the LDD regions. In one example, tab 152 and tab 154 are structures of seed material or seed layers, such as a polysilicon seeding layer. Annealing circuit 100 through the application of heat can crystallize channel 130 based on the crystal seed regions. Crystallizing a portion of channel 130 will have an effect to reduce the resistance of channel 130 in the LDD regions. The structures can result in a more conductive channel (MCC) device by reducing the resistance in the areas of the channel with traditionally high resistance.

Lowering the resistance in the drain regions or the regions of the channel isolation layers can improve the string current and allow the scaling up of 3D NAND devices to more layers with poly channels. In addition to enabling the scaling of the 3D stacks of devices, the low resistance structures can also improve performance of 3D NAND device by reducing the voltage differential between the gates, which lowers the gate to gate coupling. Lower voltage differential can reduce the gate to gate interference caused by gate to gate coupling.

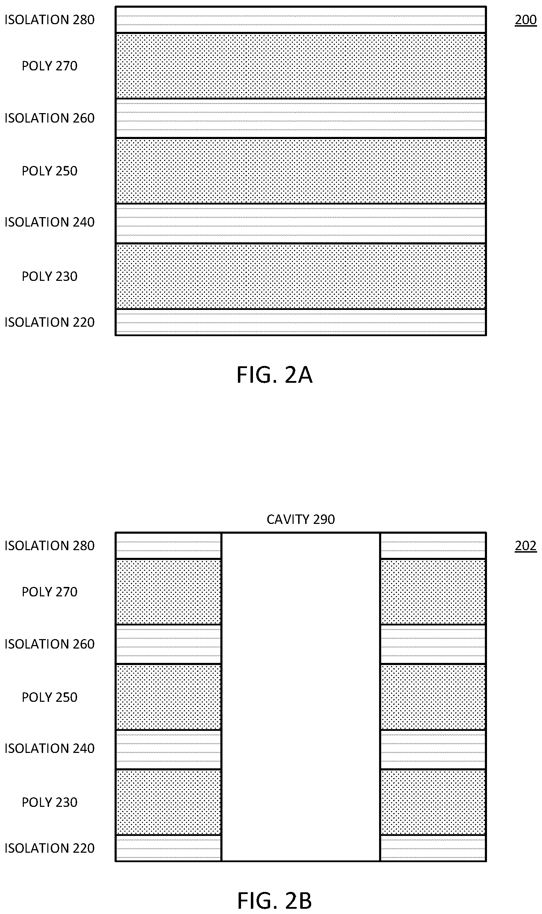

**Figures 2A-2H** are diagrammatic representations of a cross-section of stages of processing of a vertical channel with conductive structures. For purposes of example, Figures 2A-2H illustrate the processing to create a vertical channel with low resistance regions in recesses along the channel. The circuit states illustrated in Figures 2A-2H can apply to any example of a vertical channel with low resistance section described, such as circuit 100. The processing is illustrated only for a couple of layers of a 3D array. The processing will be understood to apply to other layers of the 3D array, such as applying the recessed low resistance structures on all layers of stack isolation. The drawings are for purposes of discussion, and are not necessarily to scale.

**Figure 2A** illustrates circuit state 200, with layers of a 3D array being formed in a vertical stack. Circuit state 200 illustrates a portion of an entire vertical stack or vertically stacked layers of a storage array, where the substrate or wafer on which the circuit is formed is not shown. Other layers regarding selectors are also not shown. The stack can have dozens of layers of conductor and isolation layers.

Poly 230 represents a layer of conductor for a memory cell. Isolation layer 220 represents an electrical isolation layer between the conductor of poly 230 and layers below it (not shown). Circuit state 200 also shows poly 250 and poly 270, which are conductor layers, and isolation 240, isolation 260, and isolation 280, alternating between the conductor layers. In one example, the conductor layers are layers of doped polysilicon. In one example, the isolation layers are oxide layers (e.g., tier oxide or stack oxide). In one example, the isolation layers can be or include a nitride material.

**Figure 2B** illustrates circuit state 202, in which the processing etches or removes a portion of the layers. The resulting etched isolation layer is represented as cavity 290. Cavity 290 represents a vertical cavity or vertical opening through the layers of conductor and isolation. For example, cavity 290 can be formed through an etch operation that forms holes in the 3D array structure. The etch can be performed in stages to achieve a highly vertical channel cut into the 3D array.

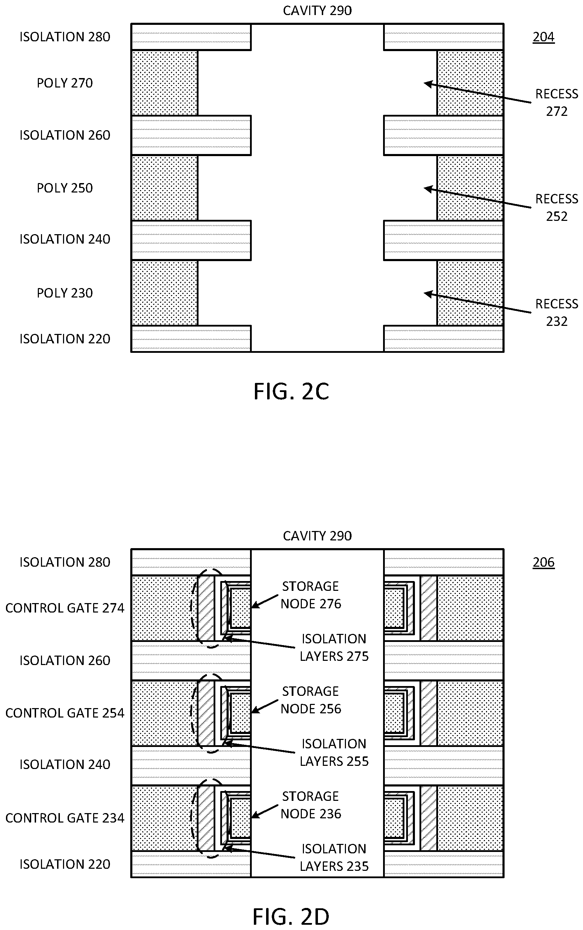

**Figure 2C** illustrates circuit state 204, in which the processing removes more material from the poly layers. The recesses created are illustrated as recess 232 for layer poly 230, recess 252 for layer poly 250, and recess 272 for layer poly 270. The recesses are formed from cavity 290 into the poly layers and between the isolation layers. The depth of the recess can be controlled by a selective etch that etches the poly conductor and not the isolation material. The recess extends away from a center of cavity 290, and will thus extend away from the vertical channel to be formed. The recess can extend away from the center of cavity 290 toward respective control gates of the memory cells, or the control gates that control access to the storage nodes. The depth of the recesses depends on the structure of the storage node to be formed for the memory cells. Circuit state 204 illustrates recesses on both sides of cavity 290, although only one side is labeled. It will be understood that cavity 290 is a three-dimensional structure, such as a vertical cylinder or circular column, whereas the view only illustrates a two-dimensional cutaway view. Thus, the recess on one side of cavity 290 can also be considered the same recess that wraps around to the other side of the view.

**Figure 2D** illustrates circuit state 206, in which the processing forms material in the exposed areas for memory cell storage. Storage node 236 represents a storage region for layer poly 230, which is identified in circuit state 206 as control gate 234. The poly layer is the control gate for storage node 236, to control access to the storage element. Isolation layers 235 represent one or more layers of isolation material to isolate the conductor of control gate 234 from the conductor of storage node 236. Storage node 256 represents a storage region for layer poly 250, which is identified as control gate 254. The poly layer is the control gate for storage node 256, to control access to the storage element. Isolation layers 255 represent one or more layers of isolation material to isolate the conductor of control gate 254 from the conductor of storage node 256. Storage node 276 represents a storage region for layer poly 270, which is identified as control gate 274. The poly layer is the control gate for storage node 276, to control access to the storage element. Isolation layers 275 represent one or more layers of isolation material to isolate the conductor of control gate 274 from the conductor of storage node 276. It will be understood that the various storage nodes will be formed in parallel. The formation of the storage nodes can include multiple processing operations that occur in series. The structure of the storage nodes is not necessarily exactly as shown. In one example, the storage nodes represent floating gates. In one example, the storage nodes represent charge trap gates or charge trap gates.

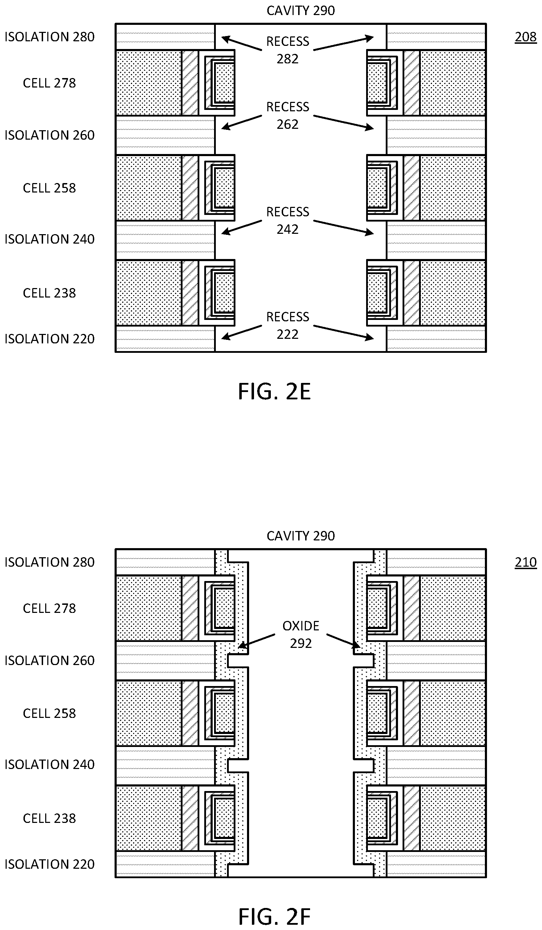

**Figure 2E** illustrates circuit state 208, in which the processing can remove material from the isolation layers. The poly layers including the gates and storage nodes are represented in circuit state 208 as memory cells. Cell 238 represents layer poly 230 as control gate 234 with storage node 236. Cell 258 represents layer poly 250 as control gate 254 with storage node 236. Cell 278 represents layer poly 270 as control gate 274 with storage node 236.

In one example, the processing executes a selective etch that removes the material of isolation 220, isolation 240, isolation 260, and isolation 280. The etch does not remove the conductor material from the storage nodes that were formed to create the memory cells. Recess 222 represents the removal of material from layer isolation 220. Recess 242 represents the removal of material from layer isolation 240. Recess 262 represents the removal of material from layer isolation 260. Recess 282 represents the removal of material from layer isolation 280. The recesses in the isolation layer regions removes material in the regions of the vertical channel that are proximate or adjacent to the isolation layers. Traditionally, the region of the channel next to the isolation layers has significantly higher resistance than the portion of the channel that passes by the storage conductors or storage nodes of the memory cells. The etching of the isolation layers removes material away from the vertical opening of cavity 290.

The recessing of the drain region between the memory cells is illustrated as part of circuit state 208. In one example, the recessing of the isolation region between the tiers of memory cells occurs after creation of the storage nodes of the memory cells. In one example, the recessing of the isolation region occurs prior to the creation of the storage nodes of the memory cells. In one example, the recessing of the isolation region occurs after deposition of the channel oxide. The recessing can occur in any stage of processing of the cell.

**Figure 2F** illustrates circuit state 210, in which the processing creates oxide 292 over the inside of the vertical opening of cavity 290. As indicated in circuit state 210, the creation of oxide 292 can be controlled to create oxide on the vertical walls of cavity 290, while not completely filling the recesses formed in circuit state 208. Oxide 292 can be referred to as the tunnel oxide or the channel oxide. As illustrated, the oxide fills the recesses, but leaves a cavity or a recess in the oxide. Thus, oxide 292 includes recesses at the location of the recesses into the isolation layers. The recesses can be filled with conductor material as described with respect to the subsequent circuit state. Oxide 292 can be referred to as a channel oxide, to provide an oxide layer between the channel conductor and the gate conductor.

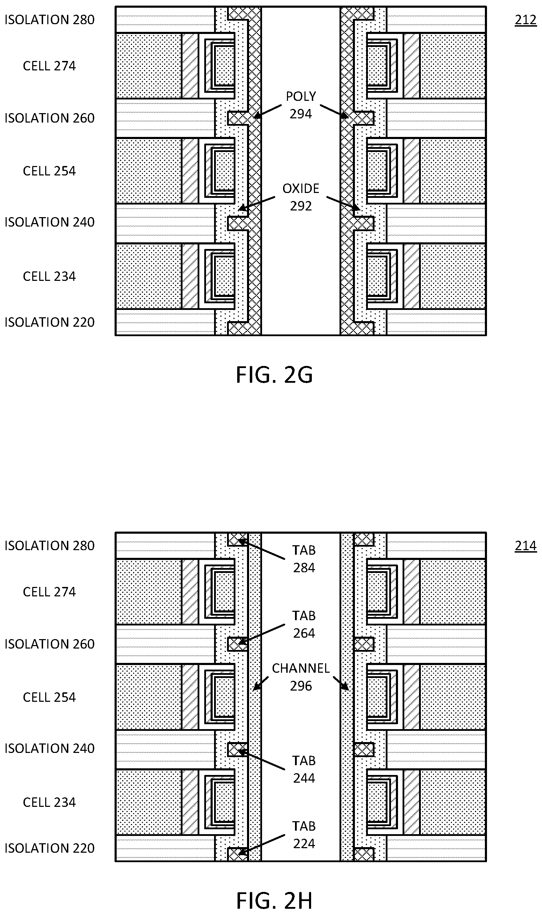

**Figure 2G** illustrates circuit state 212, in which the processing deposits or forms poly 294 on oxide 292. In one example, poly 294 represents a highly doped polysilicon material. In one example, instead of polysilicon, the channel oxide can be coated with a metal or metallic material (such as a metal silicide). It will be observed that poly 294 fills the recesses or gaps in oxide 292.

**Figure 2H** illustrates circuit state 214, in which the processing can form the channel conductor. The channel conductor is represented as channel 296. Channel 296 can be formed after removal of poly 294 from the inside wall of oxide 292. The removal of poly 294 refers to removing the poly from the vertical portions of oxide 292, while leaving poly 294 in the recesses within oxide 292. Thus, when channel 296 is formed, such as by deposition, the channel material is directly adjacent oxide 292, or formed directly on oxide 292, except for the recesses into oxide 292, which correspond to the recesses in the isolation layers.

Thus, channel 296 is directly adjacent oxide 292 next to the memory cells, and is directly adjacent the material of poly 294 that was not removed in the region of the isolation layers. In one example, channel 296 is a doped polysilicon material (such as n-type polysilicon (electron carrier majority) or p-type polysilicon (hole carrier majority). The remaining material from poly 294 is represented as tabs. The tabs electrically contact channel 296, and electrically form part of the channel. The tabs can be tab structures or other structures. The tabs are low resistance structures that electrically contacts the vertical channel material.

Tab 224 represents a tab in layer isolation 220, under cell 238. Tab 244 represents a tab in layer isolation 240, between cell 238 and cell 258. Tab 264 represents a tab in layer isolation 260, between cell 258 and cell 278. Tab 284 represents a tab in layer isolation 280, above cell 278. Tab 244 extends away from channel 296 towards cell 258 and cell 238. Tab 244 can be in a drain region between cell 238 and cell 258.

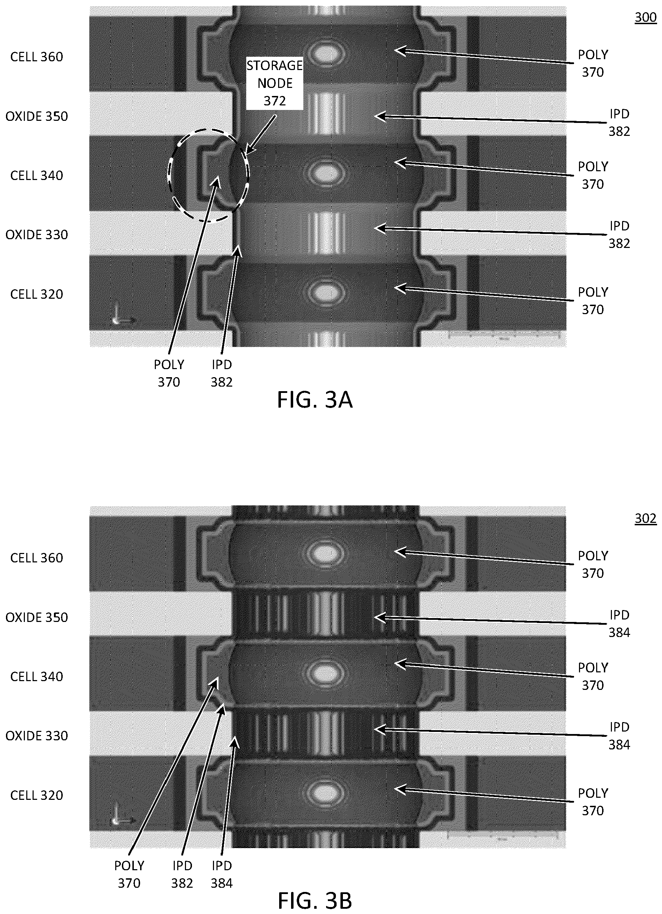

**Figures 3A-3H** are diagrammatic representations of a cross-section of stages of processing of a vertical channel with conductive structures. For purposes of example, Figures 3A-3H illustrate the processing to create a vertical channel with low resistance regions in recesses along the channel. The circuit states illustrated in Figures 3A-3H can apply to any example of a vertical channel with low resistance section described, such as circuit 100. Figures 3A-3H illustrate processing state or circuit states for images of a simulated processing sequence. The processing is illustrated only for a couple of layers of a 3D array. The processing will be understood to apply to other layers of the 3D array, such as applying the recessed low resistance structures on all layers of stack isolation. The drawings are for purposes of discussion, and are not necessarily to scale.

The diagrams provide graphic representations of what the channel could look like if the channel was cut in half and seen from the side. Thus, the diagrams illustrate a graphic to represent the 3D structure. The open hollow channel is illustrated as a cutaway of a cylindrical shape, open in the middle. The various layers are illustrated as wrapping around the open channel.

The curvature and shapes of features, dimensions of the layers, and the features of the structural elements are only examples, and are not limiting. Other structures and dimensions can be used with a vertical channel having structures to reduce resistance around an area of traditional higher resistance.

**Figure 3A** illustrates circuit state 300, in which layers of a 3D NAND structure are shown. Cell 320 represents a conductive layer that can be a memory element with the vertical channel. Cell 340 and cell 360 also represent memory cell layers. Oxide 330 and oxide 350 represent isolation layers between the memory cell layers. More specifically, oxide 330 separates cell 320 from cell 340, and oxide 350 separate cell 340 from cell 360.

Circuit state 300 illustrates the channel formation after the formation of the gates, represented by storage node 372, has been completed. Storage node 372 is illustrated in structure as an example of a floating gate. Alternatively, a charge trap structure can be implemented. Storage node 372 includes poly 370. In circuit state 300, poly 370 has been removed from the inside of the channel cavity. In one example, layers of IPD (inter-poly dielectric) cover oxide 330 and oxide 350, while poly 370 has been removed from over the oxide layers. IPD refers to one or more layers of storage node 372 other than poly 370, which is the conductor of storage node 372. IPD 382 refers to one layer of the gate. In circuit state 300, IPD 382 is exposed to the inside of the channel. The arrow and label on the left of the diagram represents a cross section view of IPD 382, and the arrows and labels on the right side point to a front view of the inside of the channel.

**Figure 3B** illustrates circuit state 302, in which a layer of IPD is removed or etched, such as by a selective etch. On the left of the diagram, poly 370 is illustrated on the level of cell 340, as is IPD 382 which has been removed from oxide 330 and oxide 350. The side view illustrates IPD 384 over oxide 330, where IPD 384 represents another layer of material in storage node 372.

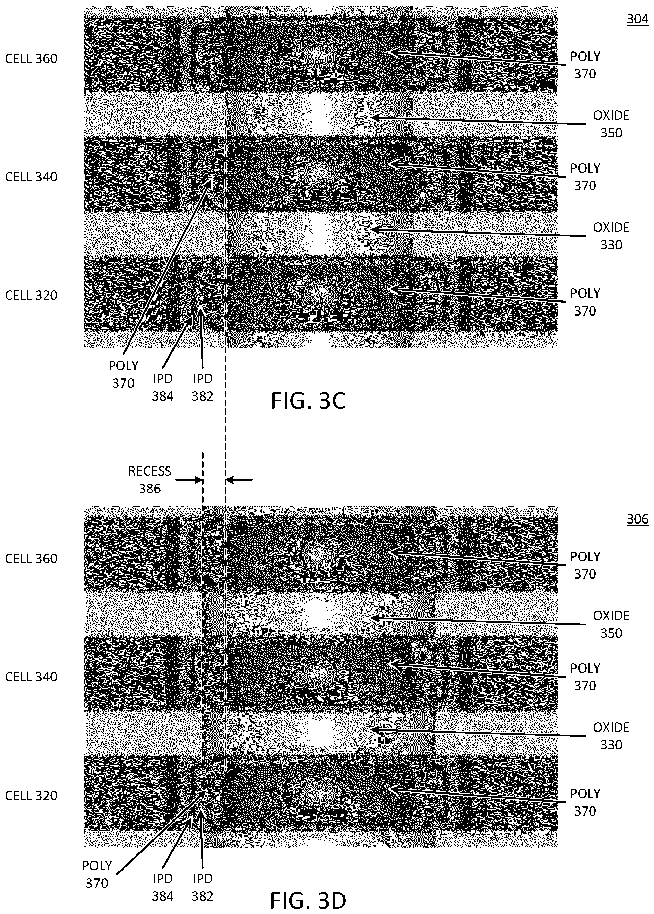

**Figure 3C** illustrates circuit state 304, in which the processing removes IPD 384 from over oxide 330 and oxide 350, exposing the oxide material of the inter-layer oxides to the hollow channel. Thus, oxide 330 and oxide 350 are illustrated on the side views of the channel as well as in the front view. The side view illustrates that poly 370, IPD 382, and IPD 384 are still present over the cell layers, but the material has been exposed over the oxide layers to expose the oxide.

**Figure 3D** illustrates circuit state 306, in which the processing recesses into oxide 330 and oxide 350. The processing can be said to perform a tier oxide recess, such as by selective etching. The selective etching can remove material in the sidewall of the vertical opening of the channel. Circuit state 306 illustrates the same materials and structures as circuit state 304. The dashed lines between the diagram illustrates recess 386 to indicate how portions of oxide 330 and oxide 350 have been removed.

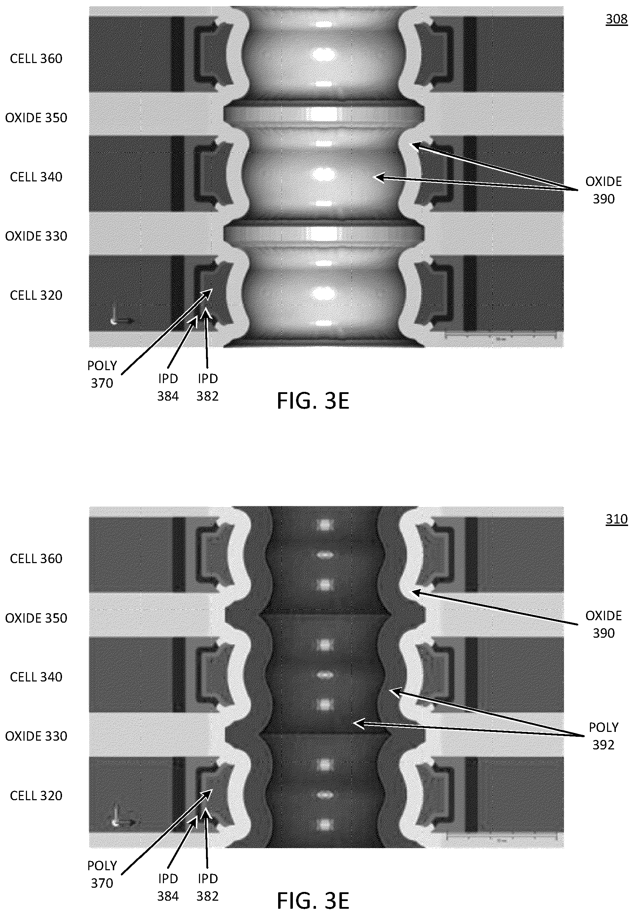

**Figure 3E** illustrates circuit state 308, in which the processing can form a channel oxide or tunnel oxide, such as by deposition processing. Oxide 390 represents the tunnel oxide. Oxide 390 covers the entire surface or wall of the hollow channel, including cell 320, oxide 330, cell 340, oxide 350, and cell 360.

**Figure 3F** illustrates circuit state 310, in which the processing can form a conductor layer over oxide 390. Poly 392 represents the conductor layer. In one example, poly 392 represent a highly doped polysilicon material. Poly 392 can be doped more heavily than poly 370 of the gates. In one example, poly 392 can be replaced by metal or metallic material.

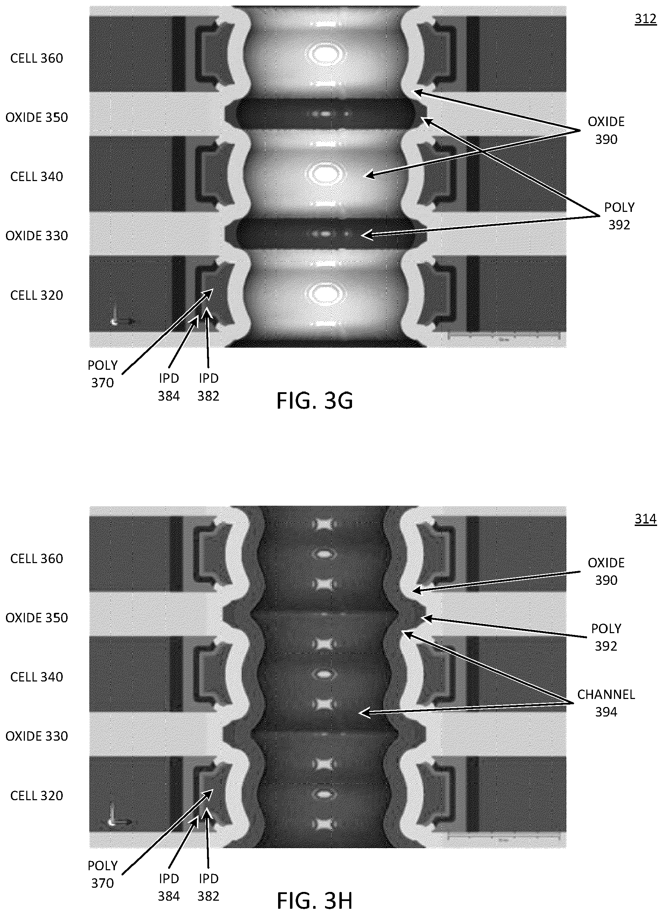

**Figure 3G** illustrates circuit state 312, in which the processing cuts poly 392 to limit the heavily doped poly to only the pocket or recess of the tier oxide. For example, it can be observed that oxide 390 includes a recess into oxide 330 and oxide 350, and leaves a depression, pocket, or cavity that is filled by poly 392. Circuit state 312 represents the result after the removal processing, in which poly 392 only remains in the recess portions, and otherwise, the hollow channel has oxide 390 exposed.

**Figure 3H** illustrates circuit state 314, in which the processing creates channel 394, such as by deposition of active channel conductor. Channel 394 is formed of conductor that is less heavily doped than poly 392, or more resistive than poly 392. The deposition of channel 394 provides the conductor for a channel. When channel 394 is doped polysilicon, the channel can be referred to as a doped hollow channel (DHC). In one example, the processing fills the channel with oxide or dielectric.

The inclusion of poly 392 provides tabs or low resistance structures that decrease the resistance of channel 394 in the drain regions or the regions of the tier separation or tier isolation material. It will be understood that poly 392, as either metal or highly doped poly, will diffuse into the material of channel 394, creating a low-ohmic contact. The material can be mixed together at the junction, resulting in rings or tabs around the conductive channel. The channel can have a ring of conductor between every pair of gates up the vertical channel.

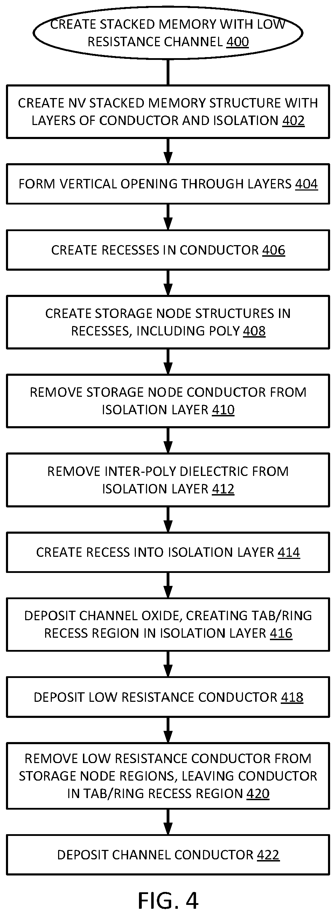

**Figure 4** is a flow diagram of an example of a process for creating a 3D memory vertical channel with conductive structures. Process 400 illustrates an example of a process to create a stacked memory or other 3D device with a vertical channel having low resistance structures to improve string current.

In one example, the processing creates a nonvolatile (NV) stacked memory structure with layers of conductor and isolation layer, at 402. In one example, the layers of conductor are layers of polysilicon. In one example, the layers of isolation can be oxide, which can be referred to as a tier oxide, which separates different tiers in the 3D stack. A material such as a nitride layer can be used instead of or in addition to the oxide layer. In one example, the processing forms a vertical opening through the layers, at 404. For example, the processing can involve etching a channel with high precision vertical walls.

In one example, the processing creates recesses within the conductor layers in the vertical opening, at 406. The creation of the recesses can be performed with an etch that reacts with the conductor (e.g., polysilicon) and does not react with, or reacts very little with, the isolation layer. After creating the recesses, the processing can create the gate structure that will turn the conductor layer into the memory cell, at 408. The processing of storage node structures, which can include a series of multiple separate processing operations, will not be identified in detail here. In one example, the storage node structure is a floating gate structure. In one example, the storage node structure is a charge trap gate structure. The storage node structure includes a gate polysilicon material or another storage node conductor, such as a metal or metal silicide.

The processing can remove the poly or conductor for the storage node from the isolation layer, while leaving the conductor in the conductor layer, at 910. The recess into the conductor layer means that the storage node conductor will have been deposited into a deeper area in the conductor layers. Selective etching can remove the conductor from the isolation layer while leaving sufficient storage node conductor in the conductor layers. In one example, the processing removes one or more layers of inter-poly dielectric (IPD) from the isolation layers, at 412. It will be understood that reference to IPD assumes the use of polysilicon as the conductor layer and storage node conductor. In an implementation where other conductors are used, other dielectric material can be used. In one example, the storage node structure includes multiple layers of dielectric or dielectric and conductor. The specific structure will depend on the implementation. The removal of the IPD layers in general refers to removing whatever layers of the storage node material that were deposited that have created a layer over the isolation layer material. The removal exposes the isolation layer.

Once the isolation layer is exposed, the processing can create a recess into the isolation layer, at 414. Again, such an operation can include selective etching. The isolation layer will correspond to a drain region of the conductive vertical channel. Thus, the recess can be a recess in the drain region of the channel, between gates of different tiers or different layers of the NV memory array. In one example, the processing deposits a channel oxide, which will create a tab/ring recess region in the isolation layer, at 416. The creation of the vertical opening is typically a circular opening. The "tab" region is a recess into the channel oxide, which can be referred to as a "ring" in that the recess can be thought of as a ring in the isolation layer around the vertical opening. The recess can form naturally by the deposition of the channel oxide, which will form on the exposed area in the vertical opening, including into the recess reaching to the isolation layer material. However, the creation of the gate oxide can be controlled to leave a recessed region.

In one example, the processing deposits a low resistance conductor, at 418, which will fill the tab/ring region that was left in the gate oxide. The low resistance conductor can e metal, metal silicide, or polysilicon. In one example, the low resistance conductor is heavily doped poly. It will be understood that reference to heavy doping or light doping is relative. The heavily doped poly has a higher concentration of conductive carriers than the poly that will be ultimately used as the vertical channel conductor. Thus, the tab region will create a region of lower resistance than the channel conductor material.

The processing can remove excess low resistance conductor from the storage node regions, leaving conductor in the tab/ring recess region, at 420. Similar to what is discussed above, the recess region can cause a deeper region of conductor to form in that region as compared to the relatively flat surface of the storage node region. Thus, removal of the conductor can be controlled to sufficiently remove the low resistance conductor from the storage node region, while leaving the conductor in the tab recesses. The processing can then deposit channel conductor, at 422. The deposition of the channel conductor, which has a higher resistance than the conductor in the tab recess region, can complete the vertical channel processing. In one example, the inside of the channel can be filled with dielectric or oxide. The deposition of the channel conductor over the tab region will provide electrical contact between the tab conductor and the channel conductor, while also depositing the channel conductor over the channel oxide in the storage node region.

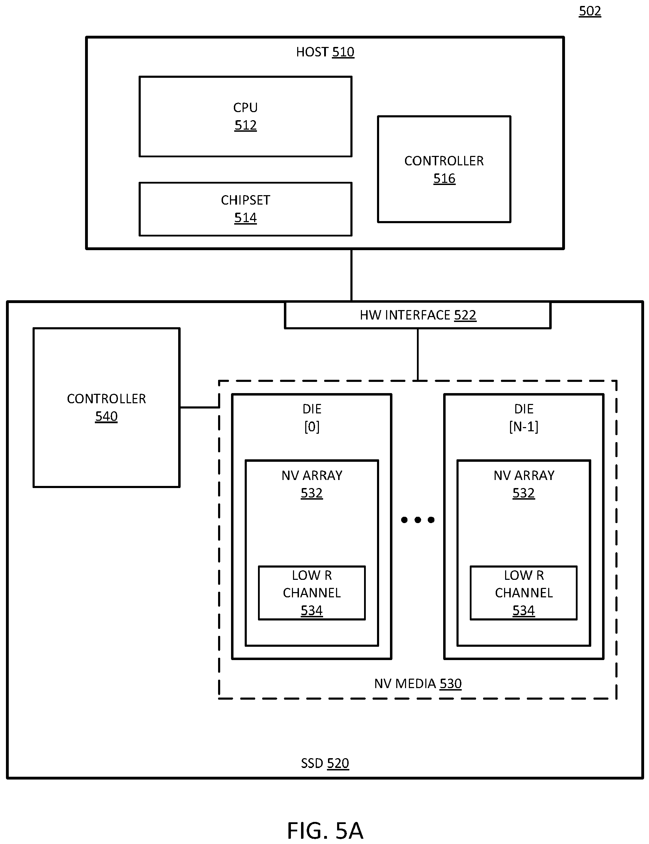

**Figure 5A** is a block diagram of an example of a system with a hardware view of a solid state drive (SSD) with a nonvolatile array having a vertical channel with conductive structures. System 502 represents components of a nonvolatile storage system that could implement nonvolatile media having a vertical string with low resistance structures in accordance with any example described, such as circuit 100, or in accordance with the processing sequences described above.

System 502 includes SSD 520 coupled with host 510. Host 510 represents a host hardware platform that connects to SSD 520. Host 510 includes CPU (central processing unit) 512 or other processor as a host processor or host processor device. CPU 512 represents any host processor that generates requests to access data stored on SSD 520, either to read the data or to write data to the storage. Such a processor can include a single or multicore processor, a primary processor for a computing device, a graphics processor, a peripheral processor, or a supplemental or auxiliary processor, or a combination. CPU 512 can execute a host OS and other applications to cause the operation of system 502.

Host 510 includes chipset 514, which represents hardware components that can be included in connecting between CPU 512 and SSD 520. For example, chipset 514 can include interconnect circuits and logic to enable access to SSD 520. Thus, host 510 can include a hardware platform drive interconnect to couple SSD 520 to host 510. Host 510 includes hardware to interconnect to the SSD. Likewise, SSD 520 includes corresponding hardware to interconnect to host 510.

Host 510 includes controller 516, which represents a storage controller or memory controller on the host side to control access to SSD 520. In one example, controller 516 is included in chipset 514. In one example, controller 516 is included in CPU 512. Controller 516 can be referred to as an NV memory controller to enable host 510 to schedule and organize commands to SSD 520 to read and write data.

SSD 520 represents a solid-state drive or other storage system or module that includes nonvolatile (NV) media 530 to store data. SSD 520 includes HW (hardware) interface 522, which represents hardware components to interface with host 510. For example, HW interface 522 can interface with one or more buses to implement a high speed interface standard such as NVMe (nonvolatile memory express) or PCIe (peripheral component interconnect express).

In one example, SSD 520 includes NV (nonvolatile) media 530 as the primary storage for SSD 520. In one example, NV media 530 is or includes a block addressable memory technology, such as NAND (not AND) or NOR (not OR). In one example, NV media 530 can include a nonvolatile media that can be block addressable or byte addressable, which stores data based on a resistive state of the memory cell, or a phase of the memory cell. For example, NV media 530 can be or include a three dimensional crosspoint (3DXP) memory or a storage array based on chalcogenide phase change material (e.g., chalcogenide glass). In one example, the NV media can be or include multi-threshold level NAND flash memory, NOR flash memory, single or multi-level phase change memory (PCM) or phase change memory with a switch (PCMS), a resistive memory, nanowire memory, ferroelectric transistor random access memory (FeTRAM), magnetoresistive random access memory (MRAM) memory that incorporates memristor technology, or spin transfer torque (STT)-MRAM, or a combination of any of the above, or other memory.

In one example, NV media 530 is implemented as multiple dies, illustrated as N dies, Die[0:{N-1)]. N can be any number of devices, and is often a binary number. SSD 520 includes controller 540 to control access to NV media 530. Controller 540 represents hardware and control logic within SSD 520 to execute control over the media. Controller 540 is internal to the nonvolatile storage device or module, and is separate from controller 516 of host 510.

The NV dies of NV media 530 include NV array 532, which represents a 3D array of storage cells based on the NV media. NV array 532 includes low resistance (R) channel 534 in accordance with any example described. Low resistance channel 534 includes structures in the vertical channel poly, in recesses between memory cells. The structures can be thought of as low resistance structures or as conductive structures or structures that increase conductivity. The structures in the recesses lower the resistance of the channel in those regions, improving overall channel resistance and improving string current through the vertical channel.

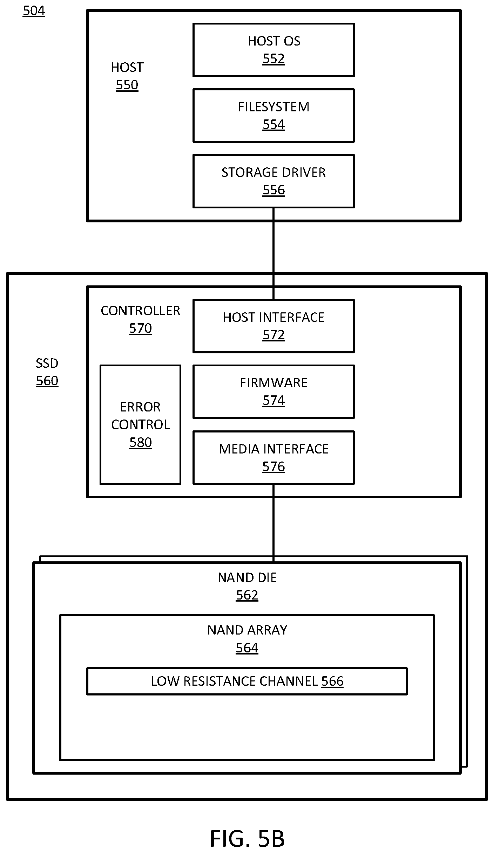

**Figure 5B** is a block diagram of an example of a logical view of system with a solid state drive (SSD) with a nonvolatile array having a vertical channel with conductive structures. System 504 provides one example of a system in accordance with system 502 of Figure 5A. System 504 illustrates the logical layers of the host and SSD of a hardware platform in accordance with system 502. System 504 can represent software and firmware components of an example of system 502, as well as physical components. In one example, host 550 provides one example of host 510. In one example, SSD 560 provides one example of SSD 520.

In one example, host 550 includes host OS 552, which represents a host operating system or software platform for the host. Host OS 552 can include a platform on which applications, services, agents, and/or other software executes, and is executed by a processor. Filesystem 554 represents control logic for controlling access to the NV media. Filesystem 554 can manage what addresses or memory locations are used to store what data. There are numerous filesystems known, and filesystem 554 can implement known filesystems or other proprietary systems. In one example, filesystem 554 is part of host OS 552.

Storage driver 556 represents one or more system-level modules that control the hardware of host 550. In one example, drivers 556 include a software application to control the interface to SSD 560, and thus control the hardware of SSD 560. Storage driver 556 can provide a communication interface between the host and the SSD.

Controller 570 of SSD 560 includes firmware 574, which represents control software/firmware for the controller. In one example, controller 570 includes host interface 572, which represents an interface to host 550. In one example, controller 570 includes media interface 576, which represents an interface to NAND die 562. NAND die 562 represents a specific example of NV media, and includes an associated NAND array 564, which represents a 3D NAND array.

NAND array 564 includes low resistance channel 566 in accordance with any example described. Low resistance channel 566 represents a vertical channel with structures in the vertical channel poly, in recesses between memory cells. The structures can be thought of as low resistance structures or as conductive structures or structures that increase conductivity. The structures in the recesses lower the resistance of the channel in those regions, improving overall channel resistance and improving string current through the vertical channel.

Media interface 576 represent control that is executed on hardware of controller 570. It will be understood that controller 570 includes hardware to interface with host 550, which can be considered to be controlled by host interface software/firmware 574. Likewise, it will be understood that controller 570 includes hardware to interface with NAND die 562. In one example, code for host interface 572 can be part of firmware 574. In one example, code for media interface 576 can be part of firmware 574.

In one example, controller 570 includes error control 580 to handle data errors in accessed data, and corner cases in terms of compliance with signaling and communication interfacing. Error control 580 can include implementations in hardware or firmware, or a combination of hardware and software.

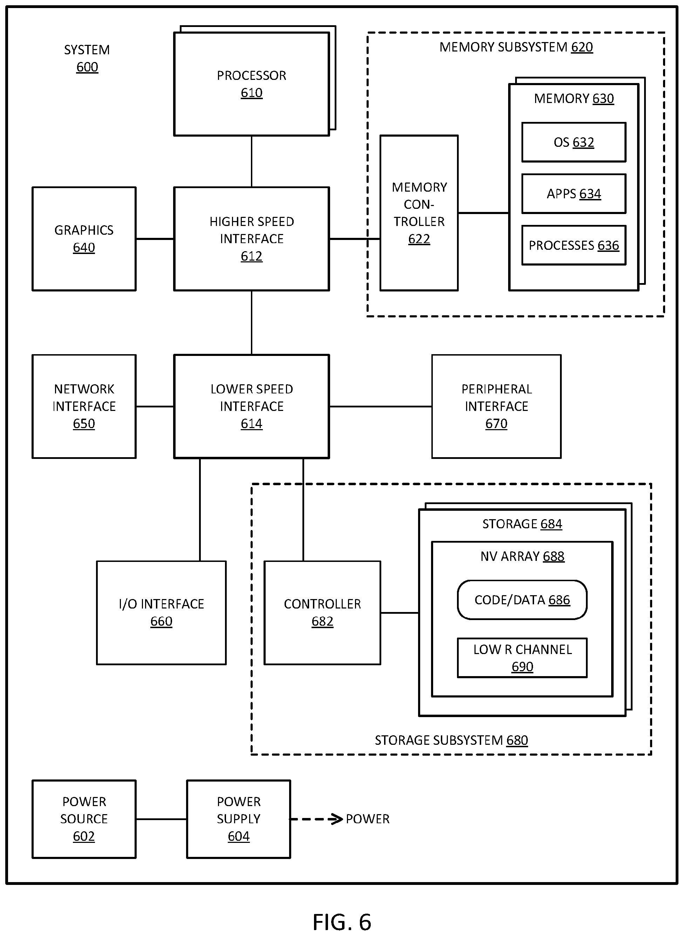

**Figure 6** is a block diagram of an example of a computing system in which a 3D memory with a vertical channel with conductive structures can be implemented. System 600 represents a computing device in accordance with any example herein, and can be a laptop computer, a desktop computer, a tablet computer, a server, a gaming or entertainment control system, embedded computing device, or other electronic device.

System 600 provides an example of a system that can include an SSD in accordance with system 502 or system 504, or another 3D stacked device with a low resistance vertical channel in accordance with circuit 100. In one example, system 600 includes storage 684 with NV array 688. NV array 688 can be, for example, a 3D NAND array or other 3D memory array. NV array 688 includes a low resistance (R) channel 690. Low resistance channel 690 can alternatively be referred to as a more conductive channel (MCC), and includes structures in the vertical channel poly, in recesses between memory cells. The structures can be thought of as low resistance structures or as conductive structures or structures that increase conductivity. The structures in the recesses lower the resistance of the channel in those regions, improving overall channel resistance and improving string current through the vertical channel.

System 600 includes processor 610 can include any type of microprocessor, central processing unit (CPU), graphics processing unit (GPU), processing core, or other processing hardware, or a combination, to provide processing or execution of instructions for system 600. Processor 610 can be a host processor device. Processor 610 controls the overall operation of system 600, and can be or include, one or more programmable general-purpose or special-purpose microprocessors, digital signal processors (DSPs), programmable controllers, application specific integrated circuits (ASICs), programmable logic devices (PLDs), or a combination of such devices.

In one example, system 600 includes interface 612 coupled to processor 610, which can represent a higher speed interface or a high throughput interface for system components that need higher bandwidth connections, such as memory subsystem 620 or graphics interface components 640. Interface 612 represents an interface circuit, which can be a standalone component or integrated onto a processor die. Interface 612 can be integrated as a circuit onto the processor die or integrated as a component on a system on a chip. Where present, graphics interface 640 interfaces to graphics components for providing a visual display to a user of system 600. Graphics interface 640 can be a standalone component or integrated onto the processor die or system on a chip. In one example, graphics interface 640 can drive a high definition (HD) display or ultra high definition (UHD) display that provides an output to a user. In one example, the display can include a touchscreen display. In one example, graphics interface 640 generates a display based on data stored in memory 630 or based on operations executed by processor 610 or both.

Memory subsystem 620 represents the main memory of system 600, and provides storage for code to be executed by processor 610, or data values to be used in executing a routine. Memory subsystem 620 can include one or more memory devices 630 such as read-only memory (ROM), flash memory, one or more varieties of random-access memory (RAM) such as DRAM, 3DXP (three-dimensional crosspoint), or other memory devices, or a combination of such devices. Memory 630 stores and hosts, among other things, operating system (OS) 632 to provide a software platform for execution of instructions in system 600. Additionally, applications 634 can execute on the software platform of OS 632 from memory 630. Applications 634 represent programs that have their own operational logic to perform execution of one or more functions. Processes 636 represent agents or routines that provide auxiliary functions to OS 632 or one or more applications 634 or a combination. OS 632, applications 634, and processes 636 provide software logic to provide functions for system 600. In one example, memory subsystem 620 includes memory controller 622, which is a memory controller to generate and issue commands to memory 630. It will be understood that memory controller 622 could be a physical part of processor 610 or a physical part of interface 612. For example, memory controller 622 can be an integrated memory controller, integrated onto a circuit with processor 610, such as integrated onto the processor die or a system on a chip.

While not specifically illustrated, it will be understood that system 600 can include one or more buses or bus systems between devices, such as a memory bus, a graphics bus, interface buses, or others. Buses or other signal lines can communicatively or electrically couple components together, or both communicatively and electrically couple the components. Buses can include physical communication lines, point-to-point connections, bridges, adapters, controllers, or other circuitry or a combination. Buses can include, for example, one or more of a system bus, a Peripheral Component Interconnect (PCI) bus, a HyperTransport or industry standard architecture (ISA) bus, a small computer system interface (SCSI) bus, a universal serial bus (USB), or other bus, or a combination.

In one example, system 600 includes interface 614, which can be coupled to interface 612. Interface 614 can be a lower speed interface than interface 612. In one example, interface 614 represents an interface circuit, which can include standalone components and integrated circuitry. In one example, multiple user interface components or peripheral components, or both, couple to interface 614. Network interface 650 provides system 600 the ability to communicate with remote devices (e.g., servers or other computing devices) over one or more networks. Network interface 650 can include an Ethernet adapter, wireless interconnection components, cellular network interconnection components, USB (universal serial bus), or other wired or wireless standards-based or proprietary interfaces. Network interface 650 can exchange data with a remote device, which can include sending data stored in memory or receiving data to be stored in memory.

In one example, system 600 includes one or more input/output (I/O) interface(s) 660. I/O interface 660 can include one or more interface components through which a user interacts with system 600 (e.g., audio, alphanumeric, tactile/touch, or other interfacing). Peripheral interface 670 can include any hardware interface not specifically mentioned above. Peripherals refer generally to devices that connect dependently to system 600. A dependent connection is one where system 600 provides the software platform or hardware platform or both on which operation executes, and with which a user interacts.

In one example, system 600 includes storage subsystem 680 to store data in a nonvolatile manner. In one example, in certain system implementations, at least certain components of storage 680 can overlap with components of memory subsystem 620. Storage subsystem 680 includes storage device(s) 684, which can be or include any conventional medium for storing large amounts of data in a nonvolatile manner, such as one or more magnetic, solid state, 3DXP, or optical based disks, or a combination. Storage 684 holds code or instructions and data 686 in a persistent state (i.e., the value is retained despite interruption of power to system 600). Storage 684 can be generically considered to be a "memory," although memory 630 is typically the executing or operating memory to provide instructions to processor 610. Whereas storage 684 is nonvolatile, memory 630 can include volatile memory (i.e., the value or state of the data is indeterminate if power is interrupted to system 600). In one example, storage subsystem 680 includes controller 682 to interface with storage 684. In one example controller 682 is a physical part of interface 614 or processor 610, or can include circuits or logic in both processor 610 and interface 614.

Power source 602 provides power to the components of system 600. More specifically, power source 602 typically interfaces to one or multiple power supplies 604 in system 600 to provide power to the components of system 600. In one example, power supply 604 includes an AC to DC (alternating current to direct current) adapter to plug into a wall outlet. Such AC power can be renewable energy (e.g., solar power) power source 602. In one example, power source 602 includes a DC power source, such as an external AC to DC converter. In one example, power source 602 or power supply 604 includes wireless charging hardware to charge via proximity to a charging field. In one example, power source 602 can include an internal battery or fuel cell source.

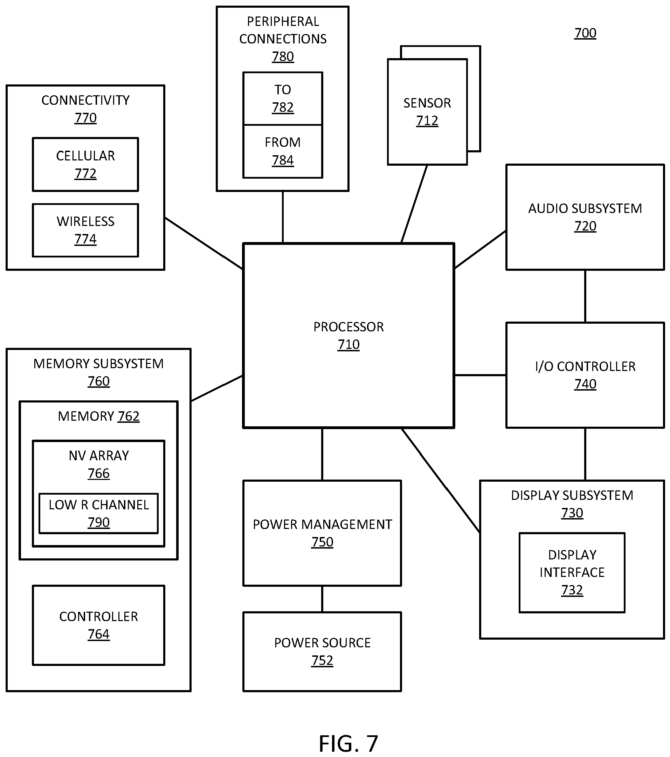

**Figure 7** is a block diagram of an example of a mobile device in which a 3D memory with a vertical channel with conductive structures can be implemented. System 700 represents a mobile computing device, such as a computing tablet, a mobile phone or smartphone, wearable computing device, or other mobile device, or an embedded computing device. It will be understood that certain of the components are shown generally, and not all components of such a device are shown in system 700.

System 700 provides an example of a system that can include an SSD in accordance with system 502 or system 504, or another 3D stacked device with a low resistance vertical channel in accordance with circuit 100. In one example, system 700 includes memory 762 with NV array 766. NV array 766 can be, for example, a 3D NAND array or other 3D memory array. NV array 766 includes a low resistance (R) channel 790. Low resistance channel 790 can alternatively be referred to as a more conductive channel (MCC), and includes structures in the vertical channel poly, in recesses between memory cells. The structures can be thought of as low resistance structures or as conductive structures or structures that increase conductivity. The structures in the recesses lower the resistance of the channel in those regions, improving overall channel resistance and improving string current through the vertical channel.

System 700 includes processor 710, which performs the primary processing operations of system 700. Processor 710 can be a host processor device. Processor 710 can include one or more physical devices, such as microprocessors, application processors, microcontrollers, programmable logic devices, or other processing means. The processing operations performed by processor 710 include the execution of an operating platform or operating system on which applications and device functions are executed. The processing operations include operations related to I/O (input/output) with a human user or with other devices, operations related to power management, operations related to connecting system 700 to another device, or a combination. The processing operations can also include operations related to audio I/O, display I/O, or other interfacing, or a combination. Processor 710 can execute data stored in memory. Processor 710 can write or edit data stored in memory.

In one example, system 700 includes one or more sensors 712. Sensors 712 represent embedded sensors or interfaces to external sensors, or a combination. Sensors 712 enable system 700 to monitor or detect one or more conditions of an environment or a device in which system 700 is implemented. Sensors 712 can include environmental sensors (such as temperature sensors, motion detectors, light detectors, cameras, chemical sensors (e.g., carbon monoxide, carbon dioxide, or other chemical sensors)), pressure sensors, accelerometers, gyroscopes, medical or physiology sensors (e.g., biosensors, heart rate monitors, or other sensors to detect physiological attributes), or other sensors, or a combination. Sensors 712 can also include sensors for biometric systems such as fingerprint recognition systems, face detection or recognition systems, or other systems that detect or recognize user features. Sensors 712 should be understood broadly, and not limiting on the many different types of sensors that could be implemented with system 700. In one example, one or more sensors 712 couples to processor 710 via a frontend circuit integrated with processor 710. In one example, one or more sensors 712 couples to processor 710 via another component of system 700.

In one example, system 700 includes audio subsystem 720, which represents hardware (e.g., audio hardware and audio circuits) and software (e.g., drivers, codecs) components associated with providing audio functions to the computing device. Audio functions can include speaker or headphone output, as well as microphone input. Devices for such functions can be integrated into system 700, or connected to system 700. In one example, a user interacts with system 700 by providing audio commands that are received and processed by processor 710.

Display subsystem 730 represents hardware (e.g., display devices) and software components (e.g., drivers) that provide a visual display for presentation to a user. In one example, the display includes tactile components or touchscreen elements for a user to interact with the computing device. Display subsystem 730 includes display interface 732, which includes the particular screen or hardware device used to provide a display to a user. In one example, display interface 732 includes logic separate from processor 710 (such as a graphics processor) to perform at least some processing related to the display. In one example, display subsystem 730 includes a touchscreen device that provides both output and input to a user. In one example, display subsystem 730 includes a high definition (HD) or ultra-high definition (UHD) display that provides an output to a user. In one example, display subsystem includes or drives a touchscreen display. In one example, display subsystem 730 generates display information based on data stored in memory or based on operations executed by processor 710 or both.

I/O controller 740 represents hardware devices and software components related to interaction with a user. I/O controller 740 can operate to manage hardware that is part of audio subsystem 720, or display subsystem 730, or both. Additionally, I/O controller 740 illustrates a connection point for additional devices that connect to system 700 through which a user might interact with the system. For example, devices that can be attached to system 700 might include microphone devices, speaker or stereo systems, video systems or other display device, keyboard or keypad devices, buttons/switches, or other I/O devices for use with specific applications such as card readers or other devices.

As mentioned above, I/O controller 740 can interact with audio subsystem 720 or display subsystem 730 or both. For example, input through a microphone or other audio device can provide input or commands for one or more applications or functions of system 700. Additionally, audio output can be provided instead of or in addition to display output. In another example, if display subsystem includes a touchscreen, the display device also acts as an input device, which can be at least partially managed by I/O controller 740. There can also be additional buttons or switches on system 700 to provide I/O functions managed by I/O controller 740.

In one example, I/O controller 740 manages devices such as accelerometers, cameras, light sensors or other environmental sensors, gyroscopes, global positioning system (GPS), or other hardware that can be included in system 700, or sensors 712. The input can be part of direct user interaction, as well as providing environmental input to the system to influence its operations (such as filtering for noise, adjusting displays for brightness detection, applying a flash for a camera, or other features).

In one example, system 700 includes power management 750 that manages battery power usage, charging of the battery, and features related to power saving operation. Power management 750 manages power from power source 752, which provides power to the components of system 700. In one example, power source 752 includes an AC to DC (alternating current to direct current) adapter to plug into a wall outlet. Such AC power can be renewable energy (e.g., solar power, motion based power). In one example, power source 752 includes only DC power, which can be provided by a DC power source, such as an external AC to DC converter. In one example, power source 752 includes wireless charging hardware to charge via proximity to a charging field. In one example, power source 752 can include an internal battery or fuel cell source.

Memory subsystem 760 includes memory device(s) 762 for storing information in system 700. Memory subsystem 760 can include nonvolatile (state does not change if power to the memory device is interrupted) or volatile (state is indeterminate if power to the memory device is interrupted) memory devices, or a combination. Memory 760 can store application data, user data, music, photos, documents, or other data, as well as system data (whether long-term or temporary) related to the execution of the applications and functions of system 700. In one example, memory subsystem 760 includes memory controller 764 (which could also be considered part of the control of system 700, and could potentially be considered part of processor 710). Memory controller 764 includes a scheduler to generate and issue commands to control access to memory device 762.

Connectivity 770 includes hardware devices (e.g., wireless or wired connectors and communication hardware, or a combination of wired and wireless hardware) and software components (e.g., drivers, protocol stacks) to enable system 700 to communicate with external devices. The external device could be separate devices, such as other computing devices, wireless access points or base stations, as well as peripherals such as headsets, printers, or other devices. In one example, system 700 exchanges data with an external device for storage in memory or for display on a display device. The exchanged data can include data to be stored in memory, or data already stored in memory, to read, write, or edit data.

Connectivity 770 can include multiple different types of connectivity. To generalize, system 700 is illustrated with cellular connectivity 772 and wireless connectivity 774. Cellular connectivity 772 refers generally to cellular network connectivity provided by wireless carriers, such as provided via GSM (global system for mobile communications) or variations or derivatives, CDMA (code division multiple access) or variations or derivatives, TDM (time division multiplexing) or variations or derivatives, LTE (long term evolution - also referred to as "4G"), 5G, or other cellular service standards. Wireless connectivity 774 refers to wireless connectivity that is not cellular, and can include personal area networks (such as Bluetooth), local area networks (such as WiFi), or wide area networks (such as WiMax), or other wireless communication, or a combination. Wireless communication refers to transfer of data through the use of modulated electromagnetic radiation through a non-solid medium. Wired communication occurs through a solid communication medium.

Peripheral connections 780 include hardware interfaces and connectors, as well as software components (e.g., drivers, protocol stacks) to make peripheral connections. It will be understood that system 700 could both be a peripheral device ("to" 782) to other computing devices, as well as have peripheral devices ("from" 784) connected to it. System 700 commonly has a "docking" connector to connect to other computing devices for purposes such as managing (e.g., downloading, uploading, changing, synchronizing) content on system 700. Additionally, a docking connector can allow system 700 to connect to certain peripherals that allow system 700 to control content output, for example, to audiovisual or other systems.

In addition to a proprietary docking connector or other proprietary connection hardware, system 700 can make peripheral connections 780 via common or standards-based connectors. Common types can include a Universal Serial Bus (USB) connector (which can include any of a number of different hardware interfaces), DisplayPort including MiniDisplayPort (MDP), High Definition Multimedia Interface (HDMI), or other type.

In general with respect to the descriptions herein, in one example, an apparatus includes: a three-dimensional (3D) NAND structure with a vertical channel to conduct current to a first storage node of a first memory cell and to a second storage node of a second memory cell, the vertical channel having a polysilicon material to conduct current, and the vertical channel having a drain region between the first storage node and the second storage node; and a recess in the drain region filled with a structure in the recess to extend away from a center of the vertical channel and toward respective control gates of the first storage node and the second storage node, to reduce resistance in the drain region along the vertical channel between the first storage node and the second storage node.

In one example of the apparatus, the structure comprises a tab of polysilicon doped more heavily than the polysilicon material of the vertical channel, to extend from the polysilicon material of the vertical channel. In accordance with any preceding example of the apparatus, in one example, the structure comprises a tab of metal to extend from the polysilicon material of the vertical channel. In accordance with any preceding example of the apparatus, in one example, the structure comprises a region of polysilicon seeding layer to crystallize the polysilicon material of the vertical channel in the drain region. In accordance with any preceding example of the apparatus, in one example, the first storage node and the second storage node comprise floating gates. In accordance with any preceding example of the apparatus, in one example, the first storage node and the second storage node comprise charge trap gates.

In general with respect to the descriptions herein, in one example, a system includes: a controller; and a storage device coupled to the controller, the storage device including a three-dimensional (3D) NAND structure with a vertical channel to conduct current to a first storage node of a first memory cell and to a second storage node of a second memory cell, the vertical channel having a polysilicon material to conduct current, and the vertical channel having a drain region between the first storage node and the second storage node; a recess in the drain region to extend away from a center of the vertical channel and toward respective control gates of the first storage node and the second storage node; and a structure in the recess to reduce resistance in the drain region along the vertical channel between the first storage node and the second storage node.

In one example of the system, the structure comprises a tab of polysilicon doped more heavily than the polysilicon material of the vertical channel, to extend from the polysilicon material of the vertical channel. In accordance with any preceding example of the system, in one example, the structure comprises a region of polysilicon seeding layer to crystallize the polysilicon material of the vertical channel in the drain region. In accordance with any preceding example of the system, in one example, the first storage node and the second storage node comprise floating gates. In accordance with any preceding example of the system, in one example, the first storage node and the second storage node comprise charge trap gates. In accordance with any preceding example of the system, in one example, the system includes one or more of: a host processor device coupled to the controller; a display communicatively coupled to a host processor; a network interface communicatively coupled to a host processor; or a battery to power the system.

In general with respect to the descriptions herein, in one example, a method includes: forming a vertical opening through vertically stacked layers of a three-dimensional (3D) NAND structure; forming a first storage node of a first memory cell and a second storage node of a second memory cell; forming a recess in a drain region between the first storage node and the second storage node; forming a conductive structure in the recess in the drain region to extend away from a center of the vertical opening and toward respective control gates of the first storage node and the second storage node; and forming a vertical channel to conduct current past the first storage node and the second storage node, the vertical channel electrically connected to the conductive structure in the recess to reduce resistance in the drain region along the vertical channel between the first storage node and the second storage node.

In one example of the method, forming the conductive structure comprises forming a tab of polysilicon doped more heavily than a polysilicon material of the vertical channel. In accordance with any preceding example of the method, in one example, forming the conductive structure comprises forming a tab of metal to extend from a polysilicon material of the vertical channel. In accordance with any preceding example of the method, in one example, forming the conductive structure comprises forming a region of polysilicon seeding layer to crystallize a polysilicon material of the vertical channel in the drain region. In accordance with any preceding example of the method, in one example, forming the recess comprises etching into a sidewall of the vertical opening prior to forming the vertical channel. In accordance with any preceding example of the method, in one example, forming the recess comprises etching into a sidewall of the vertical opening after completing formation of layers of the first memory cell and the second memory cell. In accordance with any preceding example of the method, in one example, forming the first storage node and the second storage node comprises forming floating gates. In accordance with any preceding example of the method, in one example, forming the first storage node and the second storage node comprises forming charge trap gates.

In general with respect to the descriptions herein, in one example, a computer readable storage medium includes content stored thereon, which when executed by a computing device, executes a method in accordance with any example of the method in the preceding two paragraphs.

Flow diagrams as illustrated herein provide examples of sequences of various process actions. The flow diagrams can indicate operations to be executed by a software or firmware routine, as well as physical operations. A flow diagram can illustrate an example of the implementation of states of a finite state machine (FSM), which can be implemented in hardware and/or software. Although shown in a particular sequence or order, unless otherwise specified, the order of the actions can be modified. Thus, the illustrated diagrams should be understood only as examples, and the process can be performed in a different order, and some actions can be performed in parallel. Additionally, one or more actions can be omitted; thus, not all implementations will perform all actions.

To the extent various operations or functions are described herein, they can be described or defined as software code, instructions, configuration, and/or data. The content can be directly executable ("object" or "executable" form), source code, or difference code ("delta" or "patch" code). The software content of what is described herein can be provided via an article of manufacture with the content stored thereon, or via a method of operating a communication interface to send data via the communication interface. A machine readable storage medium can cause a machine to perform the functions or operations described, and includes any mechanism that stores information in a form accessible by a machine (e.g., computing device, electronic system, etc.), such as recordable/non-recordable media (e.g., read only memory (ROM), random access memory (RAM), magnetic disk storage media, optical storage media, flash memory devices, etc.). A communication interface includes any mechanism that interfaces to any of a hardwired, wireless, optical, etc., medium to communicate to another device, such as a memory bus interface, a processor bus interface, an Internet connection, a disk controller, etc. The communication interface can be configured by providing configuration parameters and/or sending signals to prepare the communication interface to provide a data signal describing the software content. The communication interface can be accessed via one or more commands or signals sent to the communication interface.

Various components described herein can be a means for performing the operations or functions described. Each component described herein includes software, hardware, or a combination of these. The components can be implemented as software modules, hardware modules, special-purpose hardware (e.g., application specific hardware, application specific integrated circuits (ASICs), digital signal processors (DSPs), etc.), embedded controllers, hardwired circuitry, etc.

Besides what is described herein, various modifications can be made to what is disclosed and implementations of the invention without departing from their scope. Therefore, the illustrations and examples herein should be construed in an illustrative, and not a restrictive sense. The scope of the invention should be measured solely by reference to the claims that follow.

## Claims

1. An apparatus comprising:
a three-dimensional (3D) NAND structure with a vertical channel to conduct current to a first storage node of a first memory cell and to a second storage node of a second memory cell, the vertical channel having a polysilicon material to conduct current, and the vertical channel having a drain region between the first storage node and the second storage node; and
a recess in the drain region filled with a structure in the recess to extend away from a center of the vertical channel and toward respective control gates of the first storage node and the second storage node, to reduce resistance in the drain region along the vertical channel between the first storage node and the second storage node.

2. The apparatus of claim 1, wherein the structure comprises a tab of polysilicon doped more heavily than the polysilicon material of the vertical channel, to extend from the polysilicon material of the vertical channel.

3. The apparatus of claim 1, wherein the structure comprises a tab of metal to extend from the polysilicon material of the vertical channel.

4. The apparatus of any of claims 1 to 3, wherein the structure comprises a region of polysilicon seeding layer to crystallize the polysilicon material of the vertical channel in the drain region.

5. The apparatus of any of claims 1 to 4, wherein the first storage node and the second storage node comprise floating gates.

6. The apparatus of any of claims 1 to 4, wherein the first storage node and the second storage node comprise charge trap gates.

7. A method of forming a vertical channel, comprising:
forming a vertical opening through vertically stacked layers of a three-dimensional (3D) NAND structure;
forming a first storage node of a first memory cell and a second storage node of a second memory cell;
forming a recess in a drain region between the first storage node and the second storage node;
forming a conductive structure in the recess in the drain region to extend away from a center of the vertical opening and toward respective control gates of the first storage node and the second storage node; and
forming a vertical channel to conduct current past the first storage node and the second storage node, the vertical channel electrically connected to the conductive structure in the recess to reduce resistance in the drain region along the vertical channel between the first storage node and the second storage node.

8. The method of claim 7, wherein forming the conductive structure comprises forming a tab of polysilicon doped more heavily than a polysilicon material of the vertical channel.

9. The method of claim 7, wherein forming the conductive structure comprises forming a tab of metal to extend from a polysilicon material of the vertical channel.

10. The method of any of claims 7 to 9, wherein forming the conductive structure comprises forming a region of polysilicon seeding layer to crystallize a polysilicon material of the vertical channel in the drain region.

11. The method of any of claims 7 to 10, wherein forming the recess comprises etching into a sidewall of the vertical opening prior to forming the vertical channel.

12. The method of any of claims 7 to 11, wherein forming the recess comprises etching into a sidewall of the vertical opening after completing formation of layers of the first memory cell and the second memory cell.

13. The method of any of claims 7 to 12, wherein forming the first storage node and the second storage node comprises forming floating gates.

14. The method of any of claims 7 to 12, wherein forming the first storage node and the second storage node comprises forming charge trap gates.
